Europäisches Patentamt

(19) European Patent Office

Office européen des brevets

(11) Publication number : **0 442 702 A1**

## (12) EUROPEAN PATENT APPLICATION

(21) Application number : 91301126.8

(22) Date of filing : 12.02.91

(51) Int. Cl.⁵ : **H05K 3/34, B29C 67/18, B32B 31/00, G03F 7/16**

(30) Priority : 12.02.90 US 478333

(43) Date of publication of application :
21.08.91 Bulletin 91/34

(84) Designated Contracting States :
AT BE CH DE FR GB IT LI SE

(71) Applicant : **MORTON INTERNATIONAL, INC.**
**100 North Riverside Plaza, Randolph Street at the River**
**Chicago, Illinois 60606 (US)**

(72) Inventor : **Briguglio, James**
**1455 Miramer Drive**
**Balboa, California 92661 (US)**

Inventor : **Correa, Jose L.**
**2122 Baywood Drive**
**Fullerton, California 92623 (US)**
Inventor : **Crooks, Clancy**
**9193 Ethel Street**
**Cypress, California 90630 (US)**
Inventor : **Farnum, Charles L.**
**5942 Horse Canyon Road**
**Riverside, California 92509 (US)**
Inventor : **Stroud, Mark**
**10819 Glenbrier Avenue**
**Whittier 90604 (US)**

(74) Representative : **Bankes, Stephen Charles Digby et al**
**BARON & WARREN 18 South End Kensington London W8 5BU (GB)**

(54) Solder mask vacuum laminator conversion.

(57) A method of and apparatus for eliminating waste of dry film solder mask material in an existing solder mask vacuum laminator (10A) in which dry film being laminated to printed circuit boards also spaces the boards from each other and serves as an interconnection therebetween comprises modification of the laminator to adapt it for use in the vacuum lamination of boards to the surfaces of which dry film already has been loosely applied by tacking of the film to the leading and trailing edges of each board. The existing device is modified by substituting a reel (56) of carrier film (58) for that one of the dry film supply reels that supplies dry film beneath the boards to be laminated. Additionally, an automatic rewind or takeup unit (60) for the carrier web is provided at the discharge end of the laminator. The original machine shafts for the supply reels of dry film are retained for use with the supply reel for the carrier film and for the rewind unit. All other machine functions are retained.

Fig. 3

EP 0 442 702 A1

# SOLDER MASK VACUUM LAMINATOR CONVERSION

## BACKGROUND OF THE INVENTION

### 1. Field of the Invention

The present invention relates to an improved method of and apparatus for the vacuum lamination of a succession of printed circuit boards to one or both surfaces of which dry film solder mask material already has been loosely applied.

### 2. Description of the Prior Art

A solder mask is a hard, permanent layer of electrically non-conductive material which covers the surface of a printed circuit board or panel and encapsulates the traces of the printed circuit. The solder mask is patterned to fully cover the circuitry except for portions that are intentionally left exposed for the attachment thereto of other components as by soldering.

Solder masks, typically, are formed from a layer of photoimageable composition which is applied to a surface of the printed circuit board. The photoimageable layer is exposed to an actinic radiation pattern as determined by a template or artwork. Subsequent to exposure, the photoimageable layer is developed in an organic solvent or an aqueous solution or a mixture of a solvent and an aqueous solution which washes away either exposed or unexposed portions of the layer, depending upon whether the photoimageable layer is positive or negative acting. The portion of the layer remaining on the surface is then cured, as with heat and/or ultra violet light, to form a hard, permanent solder mask.

A method proposed in the prior art for applying a layer of photoimageable composition to the surface of the circuit board is to apply the composition in liquid form. After drying or partially curing, the liquid composition forms a semi-stable layer.

There are a number of advantages that accrue from applying a photoimageable layer to a circuit board in the form of a dry film rather than in liquid form. Dry films that are free of organic solvents are commercially available. The use of dry film eliminates organic solvent hazards from the work place, and additionally, the need for apparatus to protect the immediate work environment and the general environment from organic solvent emissions.

Conventionally, a dry film comprises a cover sheet of support material that is somewhat flexible but which has sufficient rigidity to provide structural support for a layer of photoimageable composition which overlies the surface of the cover sheet. The cover sheet may be formed of a polyester material such as polyethylene terephthlate (PET), such as that sold as MELINEX®.

For the protection of the photoimageable layer and to enable the dry film to be rolled, it is conventional to cover the exposed surface of the photoimageable layer with a removable protective sheet of polyethylene. An example of such a dry film is sold as LAMINAR DM® by the Dynachem Division of Morton International, Inc., the assignee of the present invention.

The protective polyethylene sheet is removed from the photoimageable composition immediately prior to the application of the dry film to the surface of the printed circuit board. Specifically, automated apparatus peels away and rolls up the protective sheet as the dry film is unrolled from a reel. The dry film is applied to the surface of the board with the photoimageable layer in direct contact with the surface of the board and is laminated thereto. The polyester cover sheet remains overlying the photoimageable layer, protecting the photoimageable layer from exposure to oxygen and from damage tending to be caused as the result of handling.

The dry film is exposed to patterned actinic radiation. The polyester cover sheet is removed immediately following vacuum lamination, prior to exposure. Depending upon the composition of the photoimageable layer, the photoimageable layer is developed with organic solvent, aqueous developer, or semi-aqueous developer, that is, a developer including both water and organic solvent. Most photoimageable composition layers require some cure subsequent to development to cause the layer to become hard and permanent and useful for serving as a solvent mask. Curing may be effected with heat and/or ultra violet radiation depending upon the composition of the photoimageable layer.

Because the polymer cover sheet is relatively rigid, the photoimageable layer cannot fully conform to irregular contours of the printed circuit board, from the flat surface of which the circuitry traces project outward. As a result, the thickness of the photoimageable layer, when laminated to the board, must be slightly greater than the projection of the traces outward of the surface of the board for the photoimageable composition to overlie the outer surfaces of the traces. Thus, outer regions of photomask exist between the portions of the circuitry from which the photoimageable composition is removed during the development of the solder mask and to which a component is to be soldered. Such outer regions pose a problem particularly with respect to components which are to be surface-mounted to the printed circuit board.

Some circuit traces are narrower at the foot thereof than at the top. In such cases, small overhangs of the photoimaging layer tend to extend outwardly along each side of each trace (an effect known as "mushrooming"). With both liquid compositions and conventional dry films, air-filled voids tend to remain below such overhangs. The air trapped in such voids may produce some oxidation of the circuit traces and may lead to eventual defects in the solder mask.

An improved dry film and process for the use thereof in the formation of a solder mask on the surface of a printed circuit board in order to eliminate the foregoing problems of both liquid and conventional dry films are disclosed and claimed in an application for United States patent bearing Serial No. 07/160,895, filed on February 26, 1988 by Leo Roos, Frederick J. Axon and James J. Briguglio, and in a continuation-in-part of that appliction bearing Serial No. 264,472, filed October 28, 1988, which applications and the inventions claimed therein are assigned to the assignee of the present invention, and the disclosures of which are incorporated herein by reference.

The improved dry film has utility as a high conformance solder mask and is available commercially being sold under the trademark ConforMASK by Morton International, Inc., the assignee of the present invention. The improved dry film includes a cover sheet formed of flexible but generally non-conforming polyester material such as PET which gives the dry film shape while allowing it to be rolled up onto a reel. On one surface of the cover sheet there is a thin layer of material, which material is referred to as a "top coat," and preferably, is soluble in the developer for the photoimageable material. The photoimageable composition forms a layer over the other surface of the top coat. A removable sheet of polyethylene protects the photoimageable composition layer. The material of the top coat is selected for transparency, strength and flexibility, and is further characterized in being more adherent to the photoimageable composition layer than to the cover sheet.

In the formation of a solder mask, as disclosed in the Roos et al. applications, the protective, removable sheet of polyethylene is peeled away, and the exposed surface of the photoimageable composition layer is tacked to a minor portion of the surface of the printed circuit board. The polyester cover sheet is removed, leaving the top coat as a protective covering on the layer of photoimageable composition. The layer of photoimageable composition at this time is firmly laminated to the surface of the board with the use of heat and vacuum and mechanical pressure in order to conform the photoimageable composition layer to the contours of the surface of the board.

In the application of the improved dry film solder mask material, it is necessary to cover the printed circuit board with a loose sheet of the film before vacuum lamination. The dry film sheet must be loose so as to allow the draw off of air enclosed between it and the surface of the circuit board before applying vacuum and mechanical pressure to conform the dry film to the board surface. The dry film outer surface is protected, during such application, by the top coat. The relatively rigid polyester cover sheet may be removed prior to or after the vacuum application process to allow for good conformation of the film to the board.

An applicator for applying the dry film to the one or both surfaces of a succession of printed circuit boards allowing, at the same time, the handling of each board with the applied film, the removal of the polyester cover sheet, and the draw off of the air enclosed between the film and the board, is disclosed and claimed in the application for United States patent bearing Serial No. : 07/318,023, filed March 2, 1989 by Robert C. Stumpf, Jose L. Correa and Charles L. Farnum, which application and the invention claimed therein are assigned to the assignee of the present invention, and the disclosure of which, by reference, is incorporated herein.

The applicator of the Stumpf et al. application is operative to cover the surface of each of a plurality, that is, a succession, of printed circuit boards with a "loose" sheet of dry film by tacking the film to leading and trailing edge areas of the surface of each of the boards as the boards are moved in succession through the applicator. The tacking is accomplished by means of heated tacking rolls that are closed to force a first region of the film into pressure contact with the surface of the board at a leading edge thereof, with the tacking rolls then being opened and subsequently closed again to force a second region of the film into pressure contact with the surface of the board at a trailing edge thereof, with the intervening portion of the film being applied to the board without the utilization of heat or pressure. That is to say, after tacking the film to the leading edge surface of the board, the rolls open again to allow the dry film to be loosely applied to the surface of the board without the use of heat or pressure. The tacking rolls close again to tack the dry film to the trailing edge surface of the board.

By the term "leading edge surface" of the board is meant the edge of the surface of the board to which it is desired to make the initial tack of the dry film solder mask to the board. Similarly, by the term "trailing edge surface" of the board is meant the edge of the surface of the board to which it is desired to have the dry film solder mask continue and at which the second tack is made.

After leading edge surface and trailing edge surface tack lamination, as disclosed in the aforesaid Stumpf et al. application for patent, the boards are transported to a solder mask vacuum applicator for lamination of the dry film over a greater area of the board surface using heat, vacuum and mechanical slapdown. With the PET cover sheets removed from the film immediately after such lamination, conformation of the photoimageable composition to the irregular contours of the surfaces of the board is enhanced.

Known in the prior art and available commercially for laminating conventional dry film to one or both sides of printed circuit boards is the VACREL® Solder Mask Vacuum Laminator, Models 100 and 300, manufactured by E. I. Du Pont de Nemours & Company of Wilmington, Delaware. This laminator, which hereinafter is referred to as the Du Pont Laminator, is described in a Du Pont Instruction Manual dated September 1977 and is said to be designed to laminate a succession of bare "laminates" or circuit boards wherein the lamination, that is, the dry film being laminated to the boards, also spaces the boards from each other and serves as an interconnection therebetween. The laminator includes an air or pneumatically operated film advance mechanism including pulling grippers that pull the film and thereby each of the boards, in sequence, into the vacuum chamber of the laminator, while at the same time withdrawing a previously laminated board from the vacuum chamber.

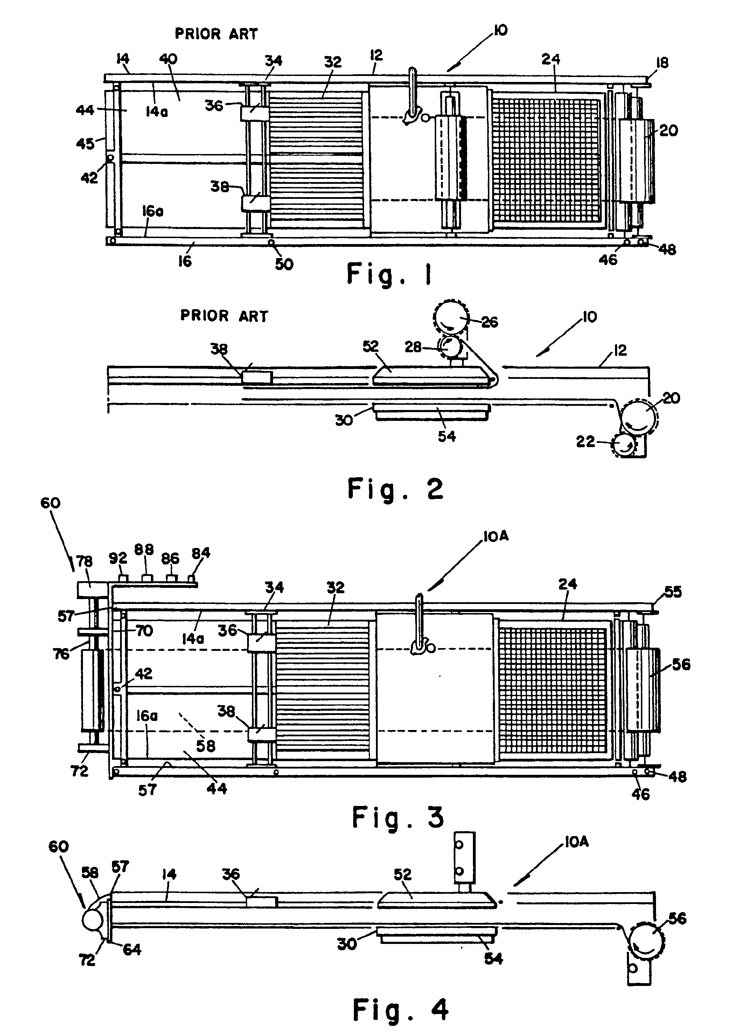

The Du Pont Laminator indicated generally by the reference numeral 10 in Figs. 1 and 2 comprises an elongated frame structure 12 which is supported between first and second parallel spaced side rails 14 and 16, respectively. Beginning at a first end 18, the laminator 10 includes a first supply reel 20 of dry film solder mask material and an associated polyolefin takeup reel 22, a board or panel loading station or feed table 24, a second supply reel 26 of film solder mask material and an associated polyolefin takeup reel 28. Also included in the laminator 10 are a heated vacuum laminating chamber 30, a table 32, an air-operated pulling mechanism 34 including spaced pulling grippers 36 and 38, a discharge table 40, and an additional or secondary gripper 42 which is provided at the end of an exit table 44 at a second end 45 of the laminator 10. Included at the first end of the laminator 10 is a "START" switch 46 and an "EMERGENCY STOP" switch 48. A "JOG" switch 50 is provided adjacent the pulling mechanism 34.

The laminator 10 is operative to laminate dry film solder mask material to one or both sides of boards. To that end, the first supply reel 20 of dry film is so positioned on the frame structure 12, as shown in Fig. 2, that the dry film drawn therefrom moves in a path underneath a board to be laminated that is placed on the loading station 24 while the second supply reel 26 of dry film is so positioned on the frame structure 12 that the dry film drawn therefrom moves in a path above the board as the latter and the film are advanced into the vacuum chamber 30.

The laminator 10 is operative to pull the dry film from the reels 20 and 26 and a board or boards to be laminated into the heated vacuum chamber 30 where lamination is effected. Heating of the board and evacuation of air occur in chamber 30.

The vacuum chamber 30 includes an upper platen 52 and a lower platen 54 which seal together when a board has been pulled into the chamber 30. At various times during each cycle, the space between each of the platens 52 and 54 is under vacuum pressure. The upper platen 52 has a flexible diaphragm which is drawn down onto the dry film and board by the vacuum in chamber 30 to apply lamination pressure.

The pulling grippers 36 and 38 of the mechanism 34 is pneumatically operated by suitable means (not shown) and, guided by grooves 14a and 16a provided in the side rails 14 and 16, respectively, pull the dry film and a board into the heated vacuum chamber 30 of the laminator 10 and withdraw a previously laminated board from the chamber 30. The secondary gripper 42 grips the film against the exit table 44 of the laminator 10 and prevents the film from being pulled back as the pulling grippers 36 and 38 are returned to the position shown in the drawing for effecting the next film and board pulling function.

In the operation of the laminator 10, a cycle timer (not shown) controls all machine functions throughout each cycle. An operator need only to place the boards on the feed table and to push the START switch 46.

The Du Pont Laminator is characterized in respect of an undesired wastage of dry film that results from using the film to space the boards from each other, and the use, also, of the pulling grippers 36 and 38. That is to say, the pulling grippers 36 and 38 limit the extent to which the length of the spaces between the successive boards may be reduced and thereby limits the extent to which wastage of the dry film may be reduced. Estimates by some in the field place such wastage as high or higher than 25%.

In the form in which it is commercially available and currently in use in the circuit board industry, the Du Pont Laminator is not suitable for vacuum laminating a succession of boards to the surfaces of which dry film already has been attached by leading edge surface and trailing edge surface tacking, as disclosed in the aforesaid Roos et al. and Stumpf et al. applications for patent. Specifically, the Du Pont Laminator cannot be operated in a manner that allows the polyester cover sheet to be removed immediately following vacuum lamination. This is because the succession of boards being vacuum laminated are attached to each other by the film which, as above mentioned, spaces the boards from each other. As a result, two or three cycles of operation of the Du Pont Laminator must take place before each of the boards, after being vacuum laminated, reaches the end 45 of the laminator 10 where the film can be cut and the polyester sheet can be removed therefrom. Consequently, by the time they reach the end 45 of the laminator 10 each of the boards and the film thereon will have cooled to a temperature below that at which removal of the polyester sheet may be effected most efficaciously. It is important to remove the polyester sheet while the film is still warm because the film then flows better and conforms more closely to the circuit traces on the surface of the board. This is the case even though there may be an initial lifting off of portions of the film from the circuit traces as the polyester sheet is removed. When the film is cold, however, it stiffens and does not flow well. As a result, when lifted off the traces as the polyester sheet is removed, the film does not flow back readily and does not conform as well to the circuit traces.

There are many, perhaps hundreds, of Du Pont Laminators currently in use in the printed circuit board industry. Many printed circuit board manufacturers would like to use ConforMASK dry film as dislcosed in the aforementioned Roos et al. and Stumpf et al. applications for patent, but are unwilling to purchase a special vacuum laminator for the purpose. They want to use their existing equipment. It is very difficult to process ConforMASK film on a standard Du Pont Laminator. Because of the unique process cycle of the ConforMASK film, it is not possible to use the Du Pont Laminator in its standard operating mode.

Thus, there is a need and a demand for improvement of the Du Pont Laminator that will allow that Laminator to be used with ConforMASK high conformance solder mask film as well as conventional solder mask film. There is a need also for an improvement that is so characterized as to enable the wastage of dry film to be eliminated and that will adapt the Du Pont Laminator for use in effecting the vacuum lamination of boards, as described hereinbefore, to which dry film already has been loosely applied.

## SUMMARY OF THE INVENTION

An object of the invention is to provide an automatic rewind system which allows the Du Pont Laminator to be used with ConforMASK high conformance solder mask film as well as with conventional dry film solder mask film.

Another object of the invention is to provide an inexpensive and facile method of and apparatus for converting the Du Pont Laminator for use with ConforMASK high conformance solder mask film in the vacuum lamination of printed circuit boards in such as way as to allow for the immediate removal, after vacuum lamination, of the polyester cover sheet.

A further object of the invention is to provide such a method and apparatus having utility in the vacuum lamination of printed circuit boards to which high conformance dry film already has been loosely applied, being tacked to the leading and trailing edge surfaces thereof.

Still another object of the invention is to provide a method of and apparatus for enabling the elimination of waste of dry film solder mask material in existing vacuum laminators of the type described by conversion thereof into a laminator having utility for the sequential vacuum lamination of a plurality of printed circuit boards to one or both surfaces of which dry film solder mask material already has been loosely applied, and in which waste of dry film is eliminated.

A further object of the invention is to provide a method of vacuum laminating printed circuit boards which have solder mask dry film loosely applied by tacking to the surfaces thereof comprising the steps of :

(a) providing a laminator feed table and a carrier web thereon on which printed circuit boards to be vacuum laminated may be placed, said carrier web being arranged to be withdrawn from a supply roll thereof positioned at a first end of the feed table ;

(b) pulling the carrier web and the printed circuit board thereon into a heated vacuum chamber that is positioned at a second end of the feed table ;

(c) evacuating air and applying laminating pressure to the printed circuit board in the vacuum chamber with the board heating and air evacuation time controlled to provide consistent lamination with no voids or air entrapment ;

(d) withdrawing the carrier web and printed circuit board thereon from the vacuum chamber and transporting the printed circuit board to an exit table while pulling another printed circuit board to be laminated into the vacuum chamber ; and

(e) winding up the carrier web on a takeup roll with winding force constantly applied to maintain the carrier web in a taut condition.

In accomplishing these and other objectives in accordance with the invention, the two supply reels of dry film of the existing solder mask vacuum laminator are dispensed with, with a reel of reusable carrier film or web being substituted for the film supply reel that is positioned at a greater distance from the vacuum chamber. In addition, a takeup structural or rewind unit is provided at the discharge or exit end of the laminator. The original machine shafts for the supply reels of dry film are retained for use with the supply reel for the carrier web. All other machine functions are retained.

In accordance with the invention, a carrier web such as polyester may be used as the transport mechanism for transporting the printed circuit boards through the vacuum laminator without the need to use dry film solder mask film as the web. The ConforMASK high conformance dry film is pre-applied to the printed circuit board. The printed circuit board with film so pre-applied is placed on the polyester web which transports the printed circuit board through the vacuum lamination process. The polyester is rewound at the exit end of the laminator in such a way that allows the carrier web to be used over and over again. The invention also maintains a constant tension in the carrier web, preventing bunching of the polyester and yielding a smooth operation. This principle allows ConforMASK film to be used on the Du Pont Laminator, modified as described, as well as to eliminate substantial film wastage, as mentioned hereinbefore. When polyester film is used as the circuit board carrier web, the thickness thereof must not allow vacuum leakage in the vacuum chamber of the laminator. Typically, the web thickness should not exceed ten mils, that is, ten thousandths of an inch (0.0254 cm.). The invention converts the Du Pont Laminator so that it can easily and inexpensively process ConforMASK film as well as conventional solder mask film.

The various features of novelty which characterize the invention are pointed out with particularity in the claims annexed to and forming a part of the specification. For a better understanding of the invention, its operating advantages, and specific objects attained by its use, reference is made to the accompanying drawings and descriptive matter in which preferred embodiments of the invention are illustrated.

## BRIEF DESCRIPTION OF THE DRAWINGS

With this description of the invention, a detailed description follows with reference being made to the accompanying drawings which form part of the specification, and of which :

Figs. 1 and 2 are schematic top plan and side views, respectively, that illustrate the structure and show the thread-up diagram of the prior art Du Pont Laminator ;

Figs. 3 and 4 are schematic top plan and side views, respectively, that illustrate the structure and show the thread-up diagram of the Du Pont Laminator as modified to include an automatic carrier web takeup or rewind system according to the present invention ;

Fig. 5 is a perspective view illustrating the structure of the carrier web takeup or rewind unit according to a first embodiment of the invention, and the means by which it may be mounted on the discharge or exit end of the laminator of Figs. 3 and 4 ;

Figs. 6, 7 and 8 are front, top and side views, respectively, of a carrier web takeup or rewind unit according to a second embodiment of the invention and the means by which it may be mounted on the discharge or exit end of the laminator of Figs. 3 and 4 ;

Fig. 9 is a perspective view illustrating the rewind unit of Figs. 6, 7 and 8 with a core chuck and core provided on the takeup shaft and also showing a portion of the carrier web wound thereon ;

Fig. 10 is a view taken along the lines 10-10 of Fig. 9 and shows a vertical section of the carrier web rewind unit side supports ;

Fig. 11A is a cross sectional view showing on an enlarged scale a bearing sleeve assembly of the carrier web rewind unit in a spring compressed takeup shaft location position ;

Fig. 11B is a cross sectional view similar to Fig. 11A of the bearing sleeve assembly of the carrier web rewind unit in a spring extended working position ;

Fig. 12 is a view showing the opening in the end of a connector sleeve for receiving the driven end of the takeup shaft ;

Fig. 13 is a fragmented perspective view showing the end of the takeup shaft that is driven by the air motor ; and

Figs. 14, 15 and 16 are front, top and side views of the carrier web rewind unit air system with the cover removed to reveal the preparation devices provided therein.

## DESCRIPTION OF THE PREFERRED EMBODIMENT

Figs. 3, 4 and 5 illustrate a first embodiment of the solder mask vacuum laminator according to the present invention. This laminator, designated generally by the reference numeral 10A, differs from the prior art laminator 10 illustrated and described in connection with Figs. 1 and 2, by the elimination of supply reels 20 and 26 of dry film and the respectively associated polyolefin takeup rolls 22 and 28, and the substitution for the reel 20 of dry film at a first end 55 of the laminator 10A of a supply roll 56 of a carrier web 58. There is provided, in addition, at the discharge or second end 57 of the laminator, an automatic carrier web or takeup roll or rewind unit 60 that is driven by an air motor 78. Use of the additional secondary gripper 42 is optional. The original machine rotatable shafts for the supply reels 20 and 26, which shafts are detachable, are retained for use in the supply roll 56 for the carrier web 58 and for the takeup roll or rewind unit 60.

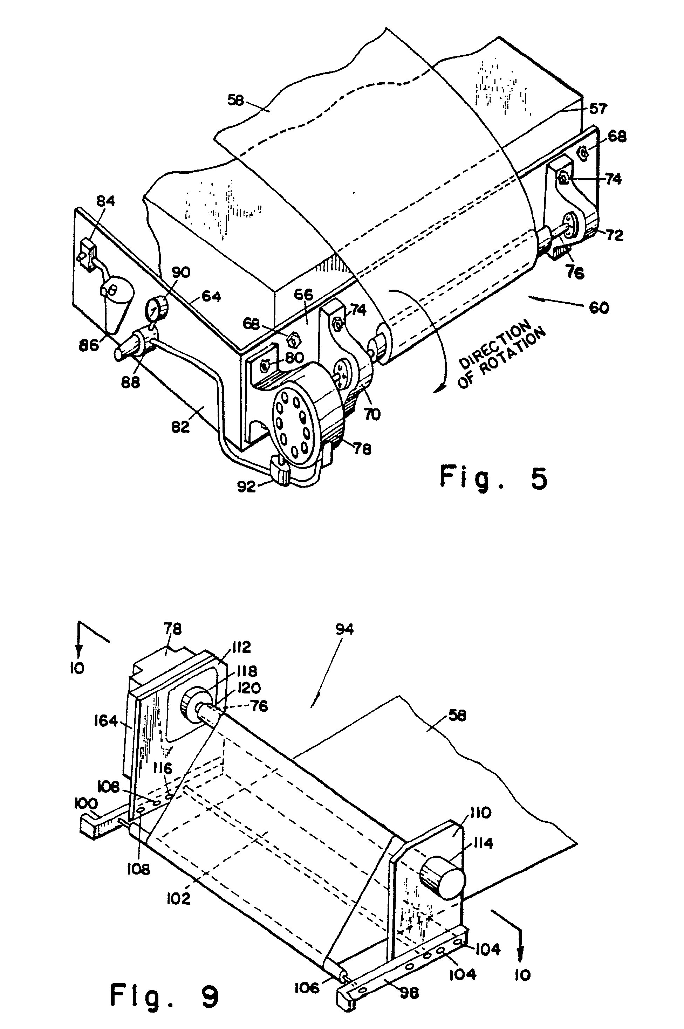

The rewind unit 60, as shown in Fig. 5, comprises an L-shaped bracket 64 having a base plate portion 66 that is attached to the second end 57 of the laminator 10A by four mounting bolts 68. Attached, in turn, to the base plate portion 66 by screws 74 are spaced pillow blocks 70 and 72, each of which has a roller bearing therein, for mounting a detachable rotatable shaft 76. While not shown in the drawing, a core chuck and an empty core may be provided, in known manner, in operative relation with the rotatable detachable shaft 76 for facilitating winding up the carrier web 58 by the rewind unit 60.

Also mounted on the bracket 64, adjacent the pillow block 70 on the base plate portion 66, as by screws 80, is an air motor 78 for driving the shaft 76.

Air for operating the air motor 78 is provided through air preparation devices that are mounted on a side plate portion 82 of bracket 64. These air preparation devices comprise an on-off valve 84, an air filter 86, an air pressure regulator 88, and an air pressure gage 90. A lubricator which normally would be used with an air motor is not used in order to avoid oil contamination. Dispensing with a lubricator is possible under the operating conditions that exist, specifically, slow rotation and light load. In the operation of the laminator 10A, air pressure is continuously applied to the air motor. A muffler 92 desirably also is employed in association with the air motor 78 for minimizing noise attending operation thereof.

Prior to the beginning of a cycle, the carrier web 58 is unwound from the supply roll 56, threaded through the vacuum chamber 30 and the pulling grippers 36 and 38 and the secondary gripper 42, and attached in winding relation to the detachable shaft 76. With the built-in timer in the laminator 10A controlling all machine functions, the operator needs only to place a board to be laminated on the carrier web 58 at the feed table 24 and to activate START switch 46. In accordance with the invention, the boards to be laminated already have the aforementioned improved dry film loosely tacked to one or both surfaces thereof at the leading and trailing edge surfaces, as hereinbefore described.

The air-operated pulling grippers 36 and 38 pull the carrier web 58 and a board placed thereon in the laminator-loading station 24 into the heated vacuum chamber 30 where the board is laminated. The board heating and air evacuation times in the vacuum chamber 30 are controlled in accordance with the automatic cycle, exactly as in the original prior art laminator 10 described above, to laminate the board free of voids and with no air entrapment.

Upon completion of the lamination of the board, the pulling grippers 36 and 38 are activated to pull the carrier web 58 and the board to withdraw, that is, advance the board from the vacuum chamber 30 to the exit table 44 and to pull into the chamber 30 another board that, meanwhile, has been placed on the feed table 24. The air-operated motor 78, being continuously powered, is constantly effective to wind up the carrier web 58 on the shaft 76 of the rewind unit 60 and thereby maintains the carrier web 58 in a taut condition during the laminating period. By way of example, but not limitation, it is noted that in an operative embodiment of the invention, the air motor 78 exerts a constant pull of about ten (10) pounds on the carrier web 58.

The carrier web 58 may be made of polyester clear film, paper or any other thin flexible material capable of withstanding the temperature within the heated vacuum chamber 30 and the pull of the pulling grippers 36 and 38 and the air-operated motor 78. Desirably, the carrier web 58 is very thin, having a thickness for example, in the range of one (1) mil, or thicker, to ten (10) mils. The thinner the carrier web 58 is, the better. A thicker carrier web makes it difficult to maintain the desired vacuum within the heated vacuum chamber 30. That is to say, a carrier web thicker than 10 mils tends to interfere excessively with the sealing action of the upper and lower platens 52 and 54, respectively, which seal together after a board to be laminated enters the vacuum chamber 30.

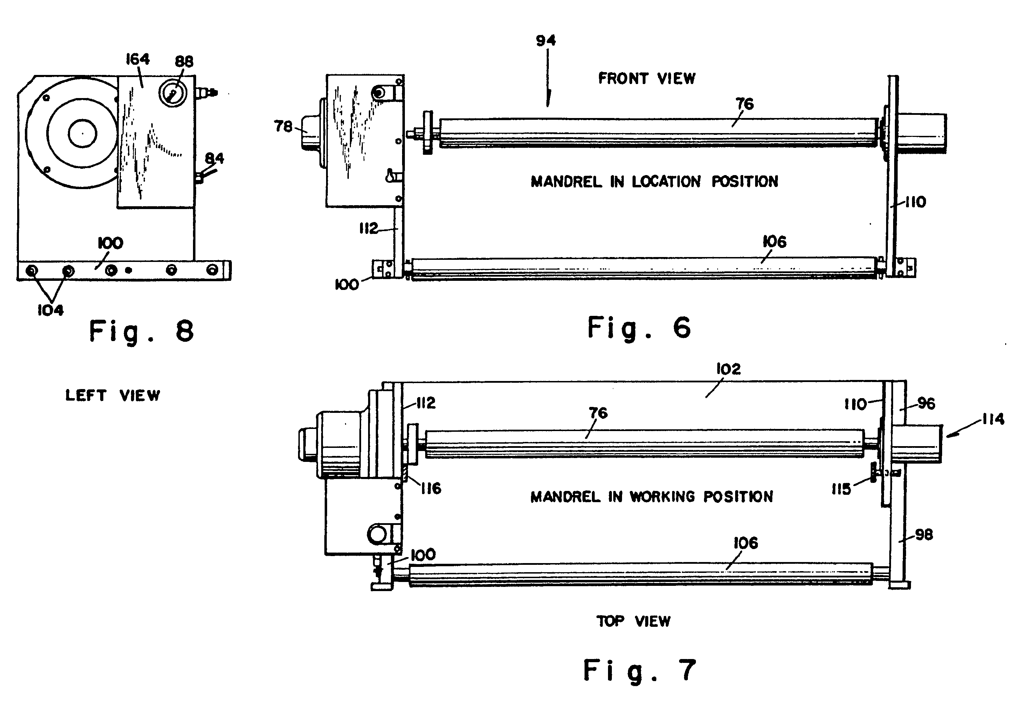

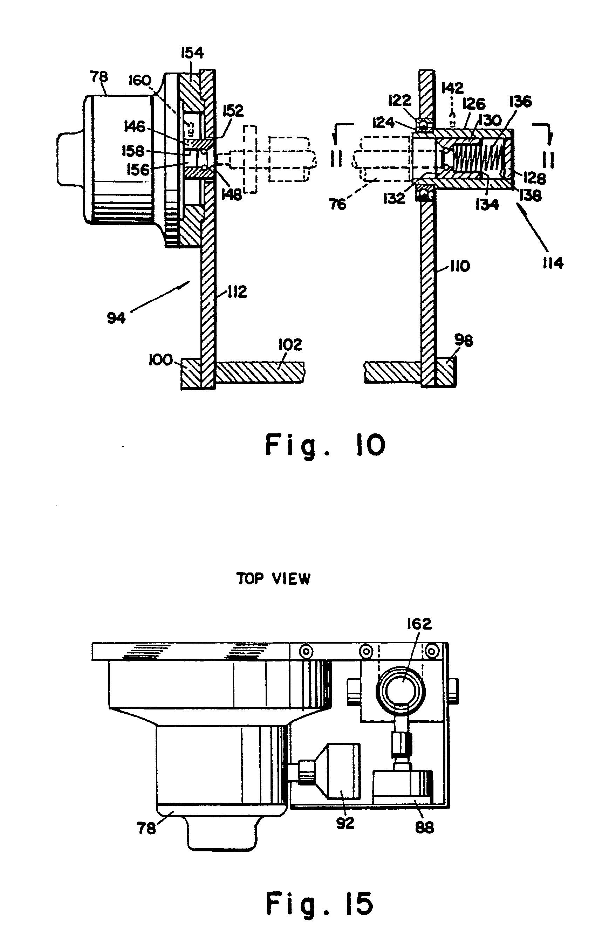

In a second embodiment of the solder mask vacuum laminator according to the invention, a modification of the automatic carrier web takeup rewind unit 60 shown in Fig. 5 is employed. The modified automatic rewind unit is illustrated in Figs. 6-16 and is designated by the reference number 94. As best seen in Figs. 7 and 9, the rewind unit 94 includes a U-shaped support frame 96 having opposed side members 98 and 100 and a cross member 102 of rectangular cross section that is attached by screws 104 between the side members 98 and 100 at one end thereof. An idler roller 106 is mounted in suitable bearings (not shown) that are provided in the ends of the side members 98 and 100 that are remote from the cross member 102.

Attached to each of the side members 98 and 100 by screws 108, as shown in Fig. 9, are opposed vertically standing side support members or side plates 110 and 112. The detachable rotatable shaft 76 is supported between side support members 110 and 112 with one end of the shaft 76 being mounted in a suitable axial slidable bearing sleeve assembly 114 in side support member 110 and attached in driven relation, at the other end, to the air motor 78. The manner of attachment of the takeup shaft 76 to the air motor 78 is shown in Fig. 10 and is described in detail hereinafter.

Attachment of the rewind unit 94 to the exit end 44 of the laminator 10A is effected by sliding the opposed side members 98 and 100 into respectively associated parallel grooves 14a and 16a in the side rails 14 and 16 of the laminator. To that end the height of each of the side members 98 and 100, as seen in the drawing, and the spacing therebetween is such as to allow them to slide with an easy and smooth but precise fit into the grooves 14a and 16a. Knurled head swivel pad clamps 115 and 116 are provided in association with respectively associated side plates 110 and 112 and respectively associated side member 98 and 100 for holding the rewind unit 94 rigidly attached to the laminator 10A after relative adjustment thereof to an optimum position for effecting the rewinding of the carrier web 58.

Knurled head swivel pad clamps 115 and 116 such as models CM-1 and CM-2 which are commercially available from Reid Tool Supply of 1518 East Katella Avenue, Anaheim, California 92805 preferably are employed. Rotation of each of the clamps 115 and 116 is effective to cause the end of the clamp to engage the inner wall of the associated groove 14a and 16a and thereby to fixedly lock the side member 98 and 100 and thereby the rewind unit 94 in position.

Fig. 9 illustrates the rewind unit 94 with a core chuck 118 and core 120 provided on the takeup shaft 76 and also shows a portion of the carrier web 58 wound thereon.

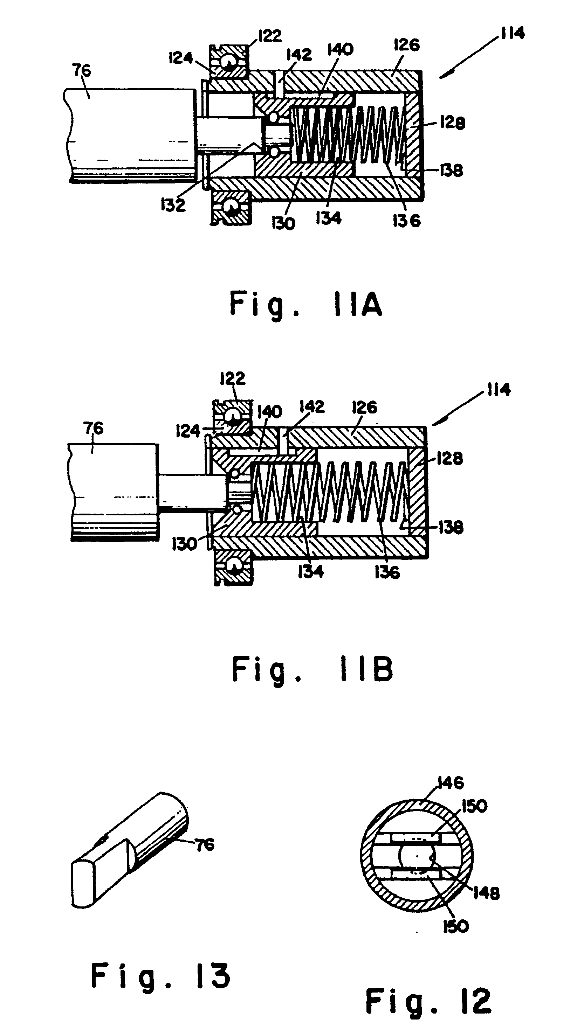

Fig. 10 is a view including a fragmented vertical sectional view taken along the lines 10-10 of Fig. 6 and shows in greater detail the side support members or plates 110 and 112. Shown also in more detail in Fig. 10 and on an enlarged scale in Figs. 11A and 11B is the axial slidable bearing sleeve assembly 114 for enabling quick release of the detachable shaft 76 and thereby of the takeup roll when all of the available carrier web 58 has been wound up thereon. The bearing assembly 114 may comprise a ball bearing single row with snap ring and two seals and includes an outer race 122 that is suitably mounted in the side plate 110 and an inner race 124 that fits on a cylindrical member 126 having a closed end 128. Contained within the cylindrical member 126 is a connector sleeve 130 having an opening 132 at one end for receiving the end of the takeup shaft 76 and an opening 134 at the other end for receiving one end of a helical spring 136. The other end of the spring 136 bears against the inner wall of the closed end 128 of member 126, being retained in a centrally located position by a centrally located projection 138 on the closed end 128. On the outer surface of the connector sleeve 130 is a groove 140. A pin 142 extending through the wall of the cylindrical member 126 allows the connector sleeve 130 to be moved axially away from the shaft 76 against the force of the spring 136 but restrains the connector sleeve 130 against relative angular movement with respect to the cylindrical member 126. Fig. 11A shows the sleeve bearing assembly 114 in a spring compressed takeup shaft location position. Fig. 11B shows the sleeve bearing assembly 114 in a spring extended working position in cooperative relation with the shaft 76.

At the other end thereof, as best seen in Figs. 10 and 12, the shaft 76 is received in a generally rectangular shaped opening 148 of a connector sleeve 146. Connector sleeve 146 includes spaced compressible members 150 in the opening 148 for providing a tight fit for the adjacent end of the takeup shaft 76, which end, as shown in Fig. 12, also is of general rectangular shape.

Connector sleeve 146, as best seen in Fig. 10, extends through an opening 152 in the side plate 112 of the structural unit 94 and is driven by the air motor 78, being rotated in a clockwise direction, to wind up the carrier web 58, as seen in Fig. 9. To that end, the air motor 78 is mounted by bolts (not shown) to the side plate 112, being separated at suitable distance therefrom by a motor spacers 154. The shaft 156 of air motor 78 extends into an opening 158 in the connector sleeve 146, which opening 158 is in alignment with the opening 148 of sleeve 146. For assuring a good driving connection between the air motor shaft 156 and the connector sleeve 146, a set screw 160 is provided in sleeve 146, as shown.

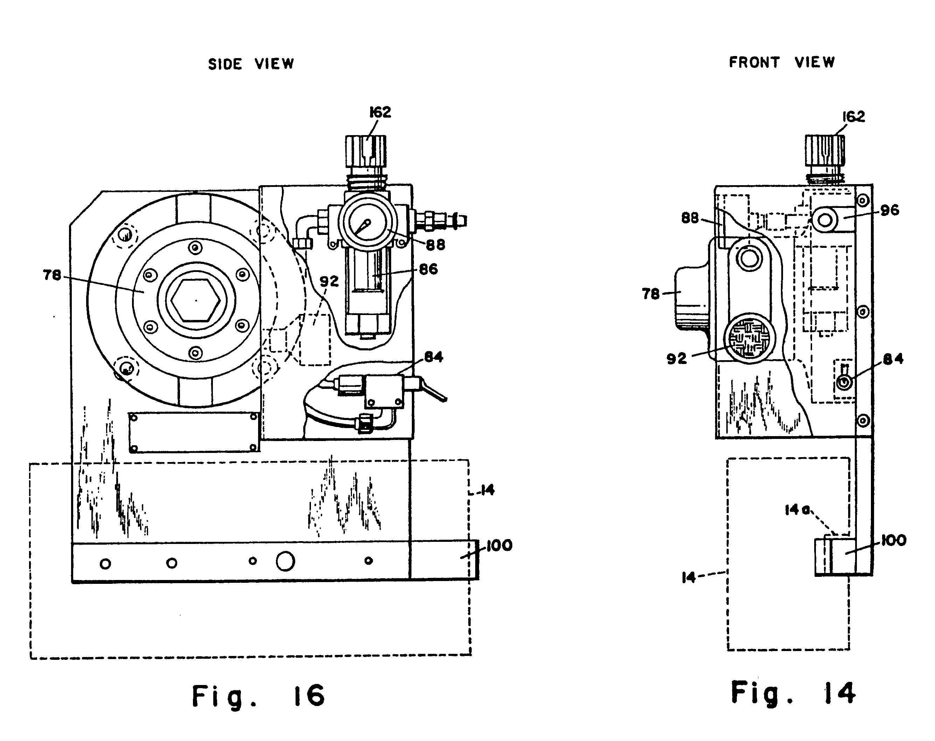

The air motor preparation devices in the second embodiment of the invention, may be identical to those shown and described in connection with the first invention embodiment. Thus, as shown in Figs. 14-16, the air preparation devices for the air motor 78 in the second embodiment include an on-off valve 84, an air filter 86, an air pressure gage 88, an air pressure regulator 90, and a muffler 92. An adjustable means 162, which means is accessible externally of the housing in which the air preparation devices are located, is provided for regulating the air pressure. In Figs. 14-16, the housing 164 for the air preparation devices has been removed to reveal the air preparation devices housed therein.

In the preparation of the laminator 10A in accordance with the second embodiment of the invention, as in the first embodiment, prior to the beginning of a cycle the carrier web is unwound from the supply reel 56, threaded through the vacuum chamber 30 and the pulling grippers 36 and 38 and the secondary gripper 42 and attached in winding relation to the core 120 on the takeup shaft 76, as seen in Fig. 9. Again, with the built-in timer in the laminator 10A controlling the machine functions, the operator is required only to place a board to be laminated on the carrier web 58 on the feed table 24 and to activate the START switch 46.

Upon such activation, the air-operated pulling grippers 36 and 38 pulls the carrier web 58 and a board placed thereon into the heated vacuum chamber 30 where the board is laminated. Upon completion of the lamination of the board, the pulling grippers 36 and 38 are activated to pull the carrier web 58 and the board to withdraw the board from the vacuum chamber 30 and to pull another board to be laminated into the vacuum chamber 30. As the pulling grippers 36 and 38 thus advance the carrier web 58 and boards through the laminator 10A, the air-operated motor 78, being continuously powered by an external air supply source (not shown), maintains a constant tension on the web 58 as the latter is wound up by the automatic rewind unit 94.

Thus, there has been provided, in accordance with the invention, a method and apparatus for converting an existing solder mask vacuum laminator that is characterized by undesired waste of dry film into a laminator having utility for the sequential vacuum lamination of printed circuit boards with high conformance ConforMASK solder mask dry film as well as with conventional film, and in which the undesired waste of dry film is elminated.

With this description of the invention in detail, those skilled in the art will appreciate that modifications may be made to the invention without departing from the spirit thereof. Therefore, it is not intended that the scope of the invention be limited to the specific embodiments illustrated and described. Rather, it is intended that the scope of the invention be determined by the appended claims and their equivalents.

## Claims

1. A method of vacuum laminating printed circuit boards which have solder mask dry film loosely applied by tacking to the surfaces thereof comprising the steps of :

   (a) providing a laminator feed table (24) and a carrier web (58) thereon on which printed circuit boards to be vacuum laminated may be placed, said carrier web being arranged to be withdrawn from a supply roll (56) thereof positioned at a first end (55) of the feed table ;

   (b) pulling the carrier web and the printed circuit board thereon into a heated vacuum chamber (30) that is positioned at a second end of the feed table ;

   (c) evacuating air and applying laminating pressure to the printed circuit board in the vacuum chamber with the board heating and air evacuation time controlled to provide consistent lamination with no voids or air entrapment ;

   (d) withdrawing the carrier web and printed circuit board thereon from the vacuum chamber and transporting the printed circuit board to an exit table (44) while pulling another printed circuit board to be laminated into the vacuum chamber (30) and ;

   (e) winding up the carrier web (58) on a takeup roll with winding force constantly applied to maintain the carrier web in a taut condition.

2. A method according to claim 1 wherein the carrier web (58) is made of polyester clear film.

3. A method according to claim 2 wherein the thickness of the polyester clear film is in the range of one to ten mills (25.4 to 254 μm).

4. A method according to claim 1 wherein the carrier web (58) is made of paper.

5. A method according to any preceding claim wherein in step (d) user is made of a pulling mechanism (34) that is movable between first and second positions and is moved from the first position to the second position to cause the withdrawal of the carrier web (58) and circuit board thereon from the vacuum chamber (30) and the transportation of the circuit board to the exit table (44), and the pulling, also, of another circuit board to be laminated into the vacuum chamber ; which method further included, between steps (d) and (e), the step of :

   (f) gripping and holding the carrier web (58) at a position adjacent the takeup roll while the pulling mechanism is returned from the second position to the first position thereof.

6. A method according to any preceding claim wherein in step (e) a continuously powered air motor (78) is provided to wind up the carrier web (58) on the takeup roll to maintain the carrier web in a taut condition.

7. A method according to any preceding claim further comprising the step of :

   (g) using the takeup roll as the supply roll (56) when all of the available carrier web (58) has been wound up on the takeup roll.

8. A laminator (10A) for vacuum laminating printed circuit boards which have solder mask dry film loosely applied to the surfaces thereof by tacking comprising,

   an elongated frame structure (12) having first and second parallel side rails (14, 16), said frame structure having a first end (55) and a second end (57),

   a feed table (24) positioned on said frame structure, said feed table having a first end and a second end with said first end being adjacent said first end (55) of said frame structure,

   a laminating vacuum chamber (30) positioned on said frame structure adjacent said second end of said feed table, said vacuum chamber including means for heating a printed circuit board placed therein, evacuating air therefrom, and applying mechanical pressure thereto (52, 54),

   a supply roll (56) of carrier web (58) positioned at said first end of said frame structure with said web being drawn over said feed table and through said vacuum chamber, said supply roll including a detachable shaft,

   a pulling mechanism (34) movable between a first position and a second position and operatively arranged with respect to said carrier web, when moved from said first position to said second position, to pull said carrier web and a printed circuit board placed thereon on the feed table into said vacuum chamber to be laminated and to withdraw a previously laminated board from the vacuum chamber, and

   a secondary gripper (42) positioned adjacent the second end (57) of said frame structure for holding said carrier web when said pulling mechanism is moved to said first position thereof from said second position,

   a takeup unit (60) positioned at said second end of said frame structure, said takeup unit including a takeup roll (76) on which said carrier web is wound up with a winding force constantly applied thereto to maintain said carrier web in a taut condition.

9. A laminator according to claim 8 wherein said takeup roll (76) of said takeup unit (60) is driven by an air motor (78).

10. A laminator according to claim 9 wherein said takeup unit includes a base plate (66) that is mounted on the second end (52) of said frame structure of said laminator, and further includes pillow blocks (70, 72) mounted in spaced relation on said base plate with said air motor (78) mounted adjacent one of said pillow blocks (70) on said base plate, and wherein said takeup roll includes a rotatable shaft (76) mounted between said pillow blocks, and means coupling said air motor in driving relation to the adjacent end of said rotatable shaft.

11. A laminator according to claim 10 wherein said rotatable shaft (76) of the takeup roll is detachable from said pillow blocks (70, 72) and said air motor (78) whereby when all of the available carrier web (58) has been wound up, the takeup roll may be used as the supply roll (56).

12. A laminator according to any one of claims 8 to 11 wherein said first and second parallel side rails (14, 16) of the frame structure (12) of said laminator each include an elongated inwardly facing groove (14a, 16a) that extends at least from the first position of said pulling mechanism (34) to the exit end (57) of said laminator, said grooves being parallel to each other,

wherein said pulling mechanism is arranged to be guided by said grooves in the movements thereof between said first and second positions, and

wherein said takeup unit (94) includes a support frame for said takeup roll, said support frame including a pair of parallel spaced side members (98, 100) with a rigid cross member (102) positioned between said side members at one end of the latter and with an idler roll (106) positioned between said side members at the other end thereof, the dimensions and spacing of said side members of said takeup structural unit being such as to allow them to fit smoothly and precisely into a respectively associated one of said grooves in said side rails of said laminator,

a transversely extending side plate (110, 112) attached to the inner side of each of said side members, said side plates being positioned in opposing parallel relation to each other,

said takeup roll having a shaft (76),

bearing means associated with each of said side plates between which bearing means said shaft of said takeup roll is positioned for rotation with one of said bearing means (114) being axially extendible through the individually associated, a first one (110), of said side plates to allow said shaft to be detached from said bearing means, and

an air motor (78) positioned adjacent the other of said bearing means on the second one (112) of side plates, the side plate associated therewith, said air motor including means cooperating with and coupling the adjacent end of said shaft for rotating driving relation therewith.

13. A laminator according to claim 12 including clamping means (115, 116) associated with each of said side members (110, 112) for clamping said takeup unit in place when said side members have been positioned in a respectively associated one of said grooves (14a, 16a) in the side rails of the laminator.

14. An automatic rewind system (94) for winding up a carrier web (58) in a vacuum laminator (10A) having an elongated frame structure (12) including spaced parallel rails (14, 16) having inwardly facing elongated grooves (14a, 16a) at the exit end thereof comprising :

a support frame including a pair of parallel spaced side members (98, 100) with a rigid cross member (102) positioned between said side members at one end of the latter,

an idler roll (106) positioned between said side members at the other end thereof,

the dimensions and spacing of said side members being such as to allow them to fit smoothly into a respectively associated one of said grooves (14a, 16a) in the side rails of the laminator,

a transversely extending side plate (110, 112) attached to the inner side of each of said side members, said side plates being positioned in opposing parallel relation to each other,

a takeup roll having a shaft (76),

bearing means associated with each of said side plates between which bearing means said shaft of said takeup roll is positioned for rotation, one of said bearing means (114) being axially extendible through the individually associated, a first one (110), of said side plates, to allow said shaft to be detached from said bearing means, and

an air motor (78) positioned adjacent the other of said bearing means on the second one (112) of said side plates, said air motor means including means co-operating with and coupling the adjacent end of said shaft for rotating driving relation therewith.

15. An automatic rewind system according to claim 14 including clamping means (115, 116) associated with each of said side members (98, 100) for clamping said support frame in place when said side members have been positioned in a respectively associated one of the grooves in the side rails of the laminator.

16. A takeup unit according to claim 15 wherein each of said clamping means (115, 116) comprises a knurled head swivel pad clamp.

PRIOR ART

Fig. 1

PRIOR ART

Fig. 2

Fig. 3

Fig. 4

Fig. 5

Fig. 9

FRONT VIEW

94

76

110

MANDREL IN LOCATION POSITION

106

112

100

78

Fig. 6

114

96

110

115

102

98

76

MANDREL IN WORKING POSITION

106

112

116

100

TOP VIEW

Fig. 7

88

84

164

100

104

Fig. 8

LEFT VIEW

Fig. 10

TOP VIEW

Fig. 15

Fig. IIA

Fig. IIB

Fig. 13

Fig. 12

16

SIDE VIEW

FRONT VIEW

162

78

92

88

86

84

14

100

Fig. 16

162

88

96

78

92

84

14a

14

100

Fig. 14

EP 0 442 702 A1

17

Application Number

EP 91 30 1126

## EUROPEAN SEARCH REPORT

**European Patent Office**

# DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | EP-A-324599 (MORTON THIOKOL)<br>* column 2, lines 28 - 51 *<br>* column 5, line 14 - column 7, line 15; figures 13-19 * | 1, 8, 14 | H05K3/34<br>B29C67/18<br>B32B31/00<br>G03F7/16 |
| D,A | EP-A-330339 (MORTON THIOKOL)<br>* claim 1 * | 1, 8, 14 | |
| A | GB-A-1161628 (DU PONT DE NEMOURS & CO)<br>* claim 1 * | 1 | |
| P,D,<br>A | EP-A-388039 (MORTON INTERNATIONAL)<br>* column 3, line 55 - column 5, line 3; claim 1 * | 1, 8, 14 | |
| A | IBM TECHNICAL DISCLOSURE BULLETIN.<br>vol. 32, no. 9b, February 90, NEW YORK US<br>pages 153 - 154;<br>"vacuum lamination of photoresist on a continuous web"<br>* the whole document * | 1, 8, 14 | |

TECHNICAL FIELDS SEARCHED (Int. Cl.5 )

H05K
B29C
B32B
G03F

The present search report has been drawn up for all claims

| Place of search | Date of completion of the search | Examiner |
|---|---|---|
| BERLIN | 24 MAY 1991 | CLOSA, D |